# EUROPEAN PATENT APPLICATION

(11) **EP 2 466 377 A1**
(43) Date of publication of application: **20.06.2012**
(21) Application number: 11193478.2
(22) Date of filing: 14.12.2011
(51) Int. Cl.: G03F 7/00, B81C 1/00

(54) **Method for the creation of complex structures on a micrometric or nanometric scale, and the complex structure thus obtained**

(30) Priority: 15.12.2010 IT MI20102295
(71) Applicant: Consiglio Nazionale Delle Ricerche, 00185 Roma (IT)
(72) Inventor: Bianchi, Michele, 40068 San Lazzaro Di Savena (IT); Cavallini, Massimiliano, 40038 Vergato (IT); Biscarini, Fabio, 40135 BOLOGNA (IT); Valle, Francesco, 40135 BOLOGNA (IT)
(74) Representative: Gervasi, Gemma

(57) **Abstract**

A method for the creation of complex structures (5) comprising the steps of depositing on a substrate (S) with at least one surface or substrate (1) that can be corroded, a material (2) to be dispersed in a corrosive solution (3); the aforementioned deposit steps are simultaneously created in a single step through the step in which distribution of said solution (3) and said material (2) is spatially guided onto the substrate (S) by applying a mould (4).

## Description

### Field of the Invention

This invention relates to a method for the creation of complex structures on a micrometric or nanometric scale, using in particular a corrosion and deposition process.

In particular, the method pursuant to the invention is advantageously used to nano- and/or micro-structure a surface via the deposit of a material and/or nano-and micro- particles and/or precursors in a single step, envisaging the use of the lithographic process known as Lithographically Controlled Wetting (for the sake of brevity, LCW) by means of a corrosive solution simultaneously to the material to be deposited.

### Background of the invention

Currently, during the processing of the integrated circuits of optical, magnetic and similar devices for example, one of the most popular and well known operating methods for the creation of complex structures is the lithographic method.

One of the key steps of the lithographic method is the step that envisages the deposit of a fine layer or film on the substrate and the generation of an in-contact mask so that, during subsequent processing thereof, the mask model can be transferred by removing the material making up the substrate or by depositing another material on the substrate itself.

A standard lithography process in sub-micrometric or nanometric processing for the creation of details, consists of depositing a film on a substrate and in subsequently exposing the film, with the relevant support, to a beam of high-energy particles such as electrons, photons or ions, possibly through a mask bearing a desired model.

The aforementioned particle beam changes the chemical structure of the area exposed by the film while leaving the unexposed area unaltered.

By immersing the substrate and the film in a developer, the area of film exposed to the energy beam or, alternatively, the unexposed area, is removed, thus producing a film that mirrors the model, or the relevant negative, traced in the aforementioned mask.

The print resolution that can be achieved in lithographic procedures is limited by the wave length of the particles used to etch the film, by the properties of the film itself and by the developing process. Further processes, such as the spatially controlled deposit of other materials requires an additional independent step as well as a complex and costly mask and/or mould alignment processes.

Other known lithographic methods include the direct use of ion or electron beams. Such methods allow high spatial resolution (tens of nanometres) but are serial methods, i.e. the patterns are written one by one in series.

Such lithographic techniques are therefore limited by the scanning speed of the particle beam. Consequently, these techniques are not especially suitable for large-scale or high-scale production.

In addition, the deposition following the structuring requires the same subsequent steps that are applied in photolithography.

Alternative lithographic techniques have recently been developed, which meet the requirement of being parallel and, at the same time, allow the simple and low-cost production of sub-micrometric and nanometric details on film.

An example is provided in US patent 5772905, which describes and proposes a lithographic method that combines standard lithographic technologies with the less costly, contact printing (embossing) method with millimetric resolutions, creating thermoplastic polymer prints in nanometric or sub-micrometric scale (nano-embossing or nano-imprinting).

The aforementioned patent describes a low-cost but high-resolution lithographic approach, which abandons the use of energy beams or particle beams. Nano-embossing entails placing a suitably-shaped mould over a polymer film placed on a rigid support and applying pressure, possibly accompanied by suitable heating of said support.

The moulding generates a series of recesses and protrusions on the film, which correspond to the respective recesses and protrusions of said mould.

The portions of film around the recesses are then removed, with a film model that mirrors the mould recesses thus being created on the substrate; the thus moulded polymer film must then be developed by known methods in order to obtain the desired product.

However, this method is limited by the modelling of the support and the film and/or the processing of the silicon, a material that is widely used in these applications. Another non-standard lithographic process relates to the aforementioned LWC or Lithographically Controlled Wetting, described for instance in US patent 2006027117.

The process described in this US patent is based on the concept of confining a solution under the protrusions of a mould placed at a distance of a few nanometres from a surface by effect of capillary force.

LCW promotes auto-organization phenomena in confined spaces delimited by the protrusions of the mould. When the solvent evaporates, the material that was initially dissolved in the solution is deposited around the protrusions thus creating the nano-structures. By optimising the conditions, objects that are smaller in dimension than the mould's protrusions can be moulded.

Structures are etched using a corrosive solution rather than depositing new material.

The moulded structures are small in dimension (up to factor 20) compared to the dimensions of the mould's structures: nano-structures can thus be created from micro-structured moulds. A current limitation of the LCW process is that said process, applied to both corrode and deposit material, requires two separate steps with the consequent alignment of the moulds, in respect of the first application of the process, thus making it extremely complex and limiting the practical applications of the process itself.

### Summary of the Invention

The scope of this invention is thus to obviate the drawbacks of the prior art as set out above.

In particular, one scope of this invention is to provide a method for the creation of complex surfaces that can contribute to the production of structured patterns through the deposition of nano-structures having a different chemical nature directly on a support and in a single step.

Another scope of this invention is to provide a method for the creation of complex surfaces without the use of lithographic techniques.

A further scope is the creation of a complex surface achieved by the method pursuant to this invention.

### Brief description of the drawings

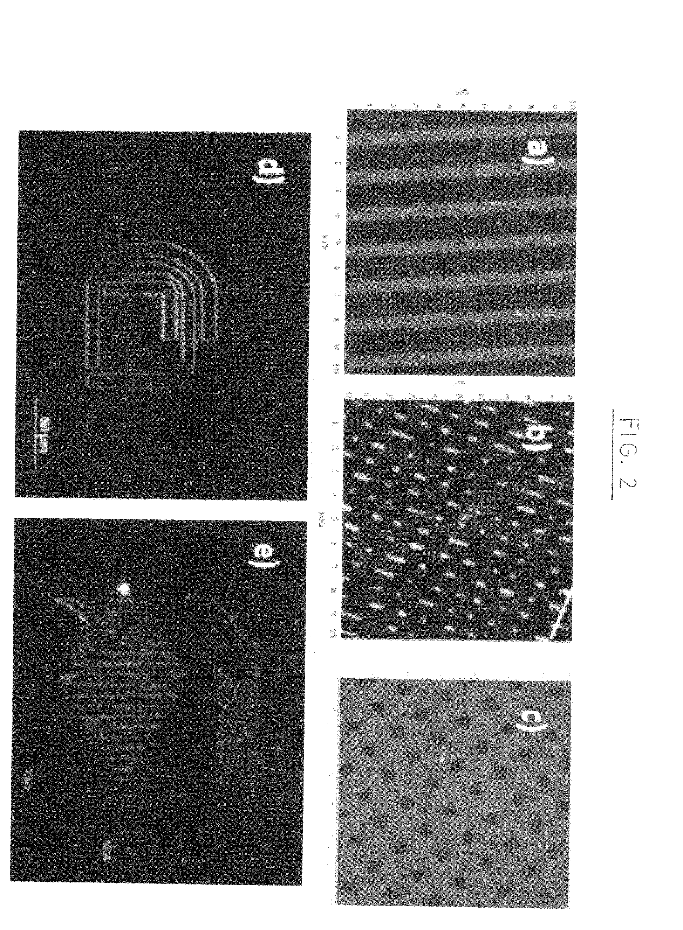

The technical characteristics of the invention, according to said scopes, can be clearly determined from the content of the claims as set out below, and the advantages thereof will become more apparent in the detailed description which follows, with reference to the annexed drawings, which illustrate several embodiments thereof, provided by way of example, wherein:

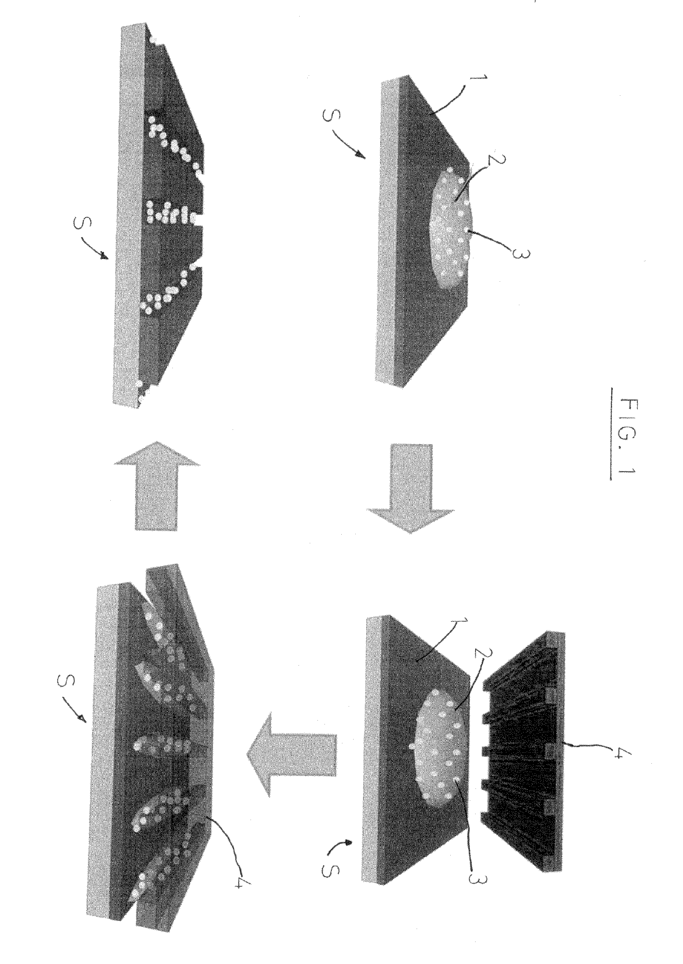

- figure 1 is a schematic view of the operational steps of the method pursuant to the invention for the creation of complex surfaces;
- figures from 2a to 2e are examples of the complex surfaces that can be obtained using the method pursuant to this invention, in detail: Fig. 2a continuous variable-dimension channels, Fig. 2b logical patterns (or patterns containing binary code information), Fig. 2c standard cavities, and Fig. 2d and Fig. 2e illustrate two different logos;

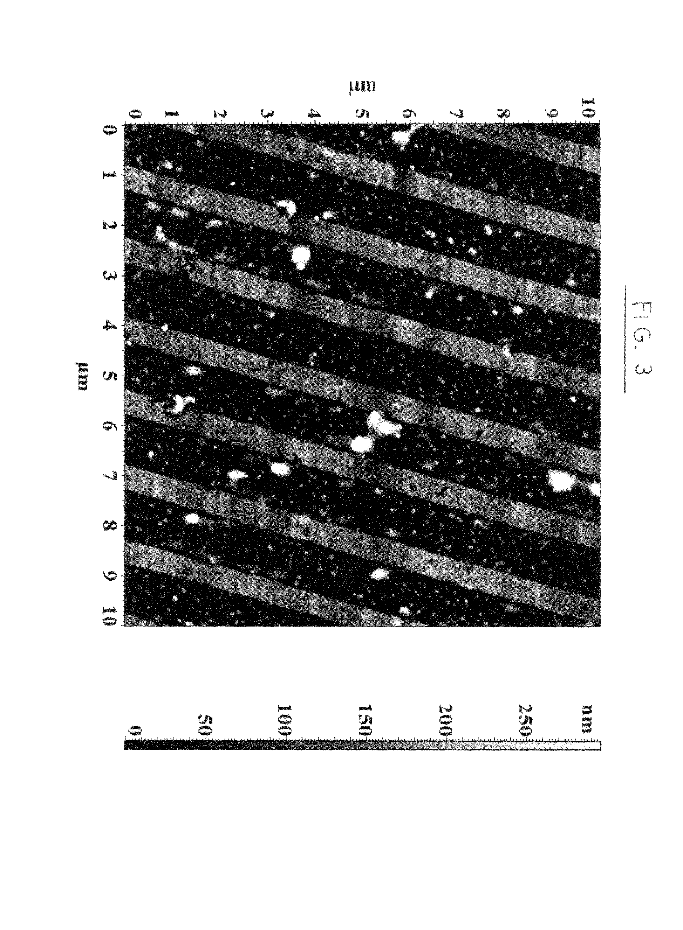

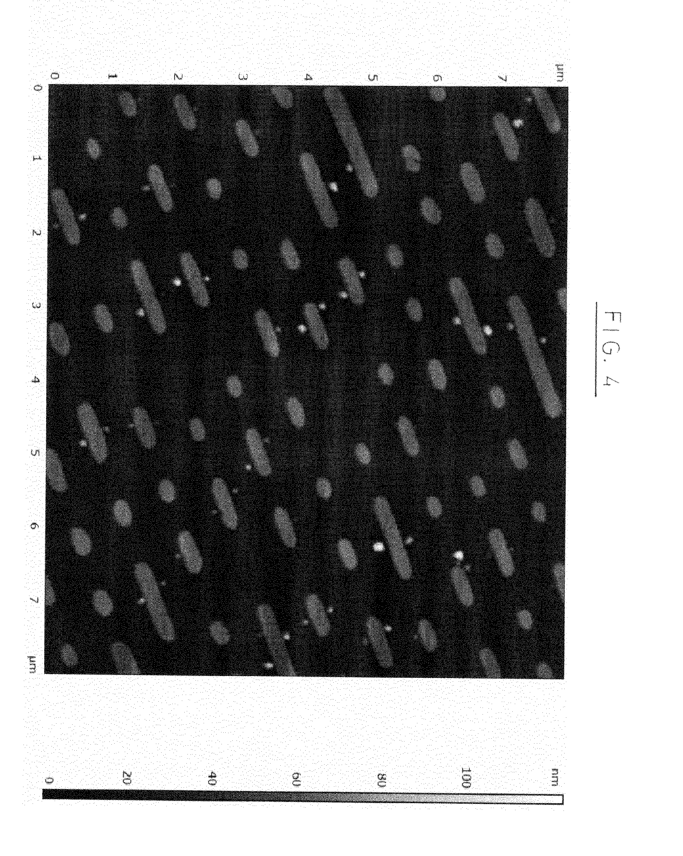

- figure 3 and figure 4 show two different atomic force microscope images (AFM) of two complex surfaces, each obtained using the method pursuant to the invention and utilising, for example, an HF, SiO₂ solution, gold Au nano particles and a mould formed by parallel lines at a distance of 1,5 µm.

### Detailed description of the Invention

In accordance with the annexed drawings, and with particular reference to figure 1, the number 1 indicates a surface or support of a substrate S, number 2 indicates a material to be deposited on substrate S, number 3 indicates a corrosive solution and number 4 indicates a mould.

In particular, explicit reference will be made hereunder, without this detracting from the details, to a substrate S defined by a support 1 in a corrodible material, such as silicon oxide, and a material 2, comprising gold nano particles, and a corrosive solution 3 comprising an HF solution.

Said elements, substrate S, support 1, material 2 and solution 3, can in any case be defined by a range of different materials, of both organic and inorganic origin, such as biological molecules (biopolymers, copolymers, proteins and so forth), silicon, titanium dioxide and similar molecules.

Reference will also be made to spatial nanometric scales, since this is the field of greatest interest in terms of the application of the described method, which is nevertheless also valid and effective for larger dimensions, such as micrometric dimensions.

In the example provided in figure 1 by way of example, the support 1 of the substrate S comprises a thermal silicon oxide wafer (1 × 1cm², thickness SiO₂ 200nm), which is, according to the method pursuant to the invention, thoroughly and preventively washed with isopropanol and ethanol, dried with nitrogen and oxygen plasma treated for 15 minutes.

A drop of the corrosive solution 3 (hydrofluoric acid 0.4%) is then deposited on the flat surface of the support 1 at the same time as deposit of the material 2. Preferably, according to this method, said deposit of the material 2 and the solution 3 on the support 1 should take place in a single step, with the material 2 that forms through a chemical reaction during the corrosive process.

An elastomeric polydimethylsiloxane (PDMS) mould 4, having a known topography is then placed above the support 1 in contact with the said material 2 and drop of the substance 3 so that distribution of the material 2 and the drop of solution 3 can be spatially guided in a controlled manner, onto the support 1.

On full or partial completion of the corrosive action of the substance 3, the mould 4 is removed and the complex structure (indicated by the number 5 in figure 1) thus obtained is thoroughly washed in ultra-pure water and dried under dry nitrogen. Figures 2a - 2e provide various examples of the geometries of the complex surfaces 5 that have been obtained using the method pursuant to the invention, in particular: continuous, variable-dimension channels (fig. 2a), logical patterns (i.e. containing binary code information) (fig. 2b), regular cavities (fig. 2c) and more complex geometries, such as for example the production of the CNR logo (fig. 2d) or of the Institute of nanostructured materials logo (fig. 2e).

According to a variant of the method pursuant to the invention, an additional corrosive treatment on the substrate S (which does not however envisage the use of mould 4 in this phase) also allows the creation of structures of even smaller dimension.

More specifically, it should be highlighted that the method pursuant to this invention has been successfully tested on silicon oxide (micro and nano electronics applications), glass (biological applications) and titanium oxide (optoelectronics and photocatalysis) using nano particles of gold, cobalt/graphite, polystyrene, polythiophene and precursors to ferromagnetic materials (Crown ether of Co/Cr).

In particular, it should also be noted that if the material 2 is a conductor, e.g. metal, the method pursuant to this invention is advantageously used in the production of conducting wires and electrodes comprising a support 1 on which the conducting material 2 is duly placed; if the material 2 has magnetic properties (or is paramagnetic of ferromagnetic), the method pursuant to this invention allows magnetically readable memory elements to be produced, which when using specific dispersed materials 2, e.g. ferromagnetic materials, can be rewriteable; if the material 2 has optical properties (e.g. photo and/or electroluminescence), optically readable memory elements can be produced, which when using specific materials 2, e.g. optical switches, can be rewriteable.

In summary, a method of structuring a surface and simultaneously organising, in a spatially controlled manner and on a sub-micrometric and/or nanometric scale, a material 2 on said support 1 so that the properties of the material 2, originally dissolved in a corrosive solution 3 combined with the structuring of the substrate S, define the characteristics of the complex surface 5 as the end product of the abovementioned method.

The complex surface 5 thus obtained as the spatially controlled distribution of the material 2 on support 1, also known as the chemical pattern, is useful in various production processes, such as for example a substrate for the differential development of fine films or a step in the production process; advantageously, this method can also be used in conjunction with organic and/or inorganic and/or biological supports to obtain light emitting diodes, field-effect transistors, diodes and other similar devices.

Where the dispersed material 2 is a semiconductor, an electrode or a film or a fine layer in which the semiconductor is the active element, can be obtained.

This invention also relates to an electrode, a rewritable or non-rewriteable optically readable memory element, a rewriteable or non-rewriteable magnetically readable memory element, i.e. in summary, a spatially structured chemical pattern obtained by the abovementioned method,

The invention achieves its scopes and, in particular, this method allows patterns to be produced directly on a support without reliance on lithographic processes.

The described method is able to operate on a micrometric and nanometric scale and relates to the nanotechnology sector.

The invention thus devised is suitable for industrial application; it may also undergo a number of modifications and embodiments, all of which fall within its creative design; in addition, all the details can be replaced by technically equivalent elements.

## Claims

1. A method for the creation of complex structures (5) comprising the steps for depositing on a substrate (S), having at least one corrodible surface or support (1), a material (2) to be dispersed and a corrosive solution (3), **characterised in that** said depositing steps are carried out simultaneously through the step of spatially guiding the distribution of said solution (3) and said material (2) onto said substrate (S) by applying a mould (4).

2. A method, as claimed in claim 1, **characterised in that** said mould (4) and said corrosive solution (3) are removed by means of any technique when the corrosive solution (3) has either partially or fully completed its corrosive action.

3. A method, as claimed in claim 1 or 2, **characterised in that** said mould (4) is made of a polymeric material, such as polydimethylsiloxane (PDMS).

4. A method, as claimed in any one of the preceding claims, from 1 to 3, **characterised in that** said material (2) is an element that is chemically the same or different from the corrosive solution (3).

5. A method, as claimed in any one of the preceding claims, from 1 to 4, **characterised in that** said material (2) comprises an organic and/or biological and/or inorganic material or mixtures of said materials in any proportion.

6. A method, according to any one of the preceding claims, from 1 to 5, **characterised in that** the substrate (S) comprises either an organic or inorganic material.

7. A method, as claimed in any one of the preceding claims, from 1 to 6, **characterised in that** said corrosive solution (3) is organic and/or inorganic and/or biological or a mixture thereof in any proportion.

8. A method, as claimed in one of the preceding claims, from 1 to 6, **characterised in that** the corrosive solution (3) comprises a solution of organic, inorganic compounds and/or elements or a mixture of said compounds in any proportion.

9. A method, as claimed in one of the preceding claims, from 1 to 8, **characterised in that** said material (2) is formed by a chemical reaction during application of the corrosive process.

10. A complex surface (5) or spatially structured chemical pattern, **characterised in that** it is obtained in accordance with the method described in one or more of the preceding claims, from 1 to 9, said pattern being defined by said material (2).
